# DEMANDE DE BREVET EUROPEEN

(11) **EP 2 824 704 A1**
(43) Date de publication de la demande: **14.01.2015**
(21) Numéro de dépôt: 13305996.4
(22) Date de dépôt: 12.07.2013
(51) Int. Cl.: H01L 23/498, G06K 19/077

(54) **Module électronique et son procédé de fabrication**

(71) Demandeur: Gemalto SA, 92190 Meudon (FR)
(72) Inventeur: Depoutot, Frédéric, 13705 LA CIOTAT (FR)

(57) **Abrégé**

L'invention porte sur un module électronique comportant un film diélectrique (120) et une couche métallisée (110) comprenant au moins une plage de contact (111), ledit module électronique étant caractérisé en ce que le film diélectrique (120) forme une face externe dudit module et comprend au moins une ouverture (121), ménagée dans son épaisseur et débouchant sur ladite au moins une plage de contact (111) de la couche métallisée (110).

## Description

L'invention se rapporte au domaine technique des modules électroniques, aux procédés de fabrication des modules et modules électroniques, ainsi qu'aux dispositifs électroniques, en particulier aux cartes à puce, comprenant un tel module ou module électronique. Plus précisément, l'invention se rapporte aux modules électroniques réalisés selon la technologie dite « Flip chip ».

De façon générale, les modules électroniques sont formés par assemblage d'un film diélectrique et d'une couche métallisée. La couche métallisée comprend des plages de contact d'un bornier de connexion, destinées à affleurer la surface d'un dispositif électronique tel qu'une carte à puce. Sur la face du film diélectrique, opposée à la couche métallisée, est fixée une puce électronique, dont les plots de contact sont connectés aux différentes plages de contact de la couche métallisée.

Classiquement, la puce est fixée sur le film diélectrique sa face active tournée vers l'extérieur du film, et ses plots de contact sont connectés aux plages de contact par l'intermédiaire de fils d'or qui passent à travers des réservations pratiquées dans l'épaisseur du film diélectrique, au regard des plages de contact. La puce est ensuite enrobée dans une résine de protection.

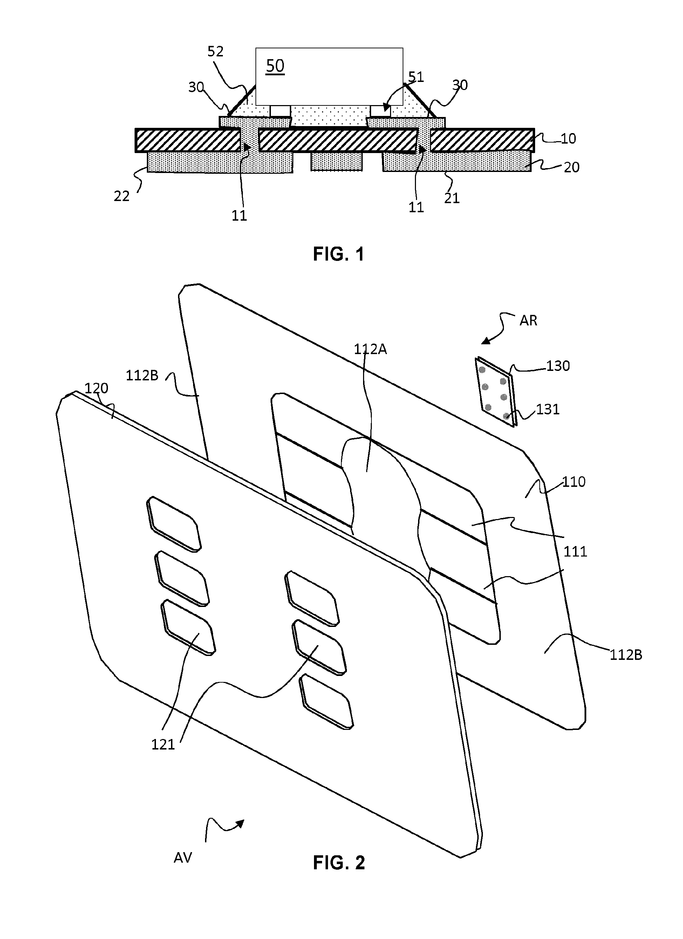

Une autre technique, connue sous la marque enregistrée FCOS (acronyme anglais pour « Flip Chip On Substrate »), consiste à retourner la puce de sorte que sa face active soit disposée en regard du film diélectrique. Une telle technique est schématisée sur la Figure 1 qui représente une vue schématique en coupe d'un module dont la puce est connectée selon la technique « puce retournée » ou « Flip Chip ». Selon cette technique, le film support, sur lequel sont réalisés des modules, est formé par le film diélectrique 10 assemblé à deux couches métallisées 20, 30 disposées sur chacune de ses faces. Une première couche métallisée 20 est destinée à former le bornier de connexion du module et comprend des plages de contact telles que référencées 21, 22 sur la Figure 1. Les plages de contact sont réalisées, de façon connue, conformément à la norme ISO7816-2 et sont en général au nombre de 6 ou 8. La deuxième couche métallisée, référencée 30, comprend des zones conductrices destinées à être reliées aux plages de contact de la première couche métallisée 20 par l'intermédiaire de puits conducteurs 11 pratiqués dans l'épaisseur du film diélectrique au droit des plages de contact 21, 22. La puce électronique 50 est alors reportée de sorte que sa face active soit disposée en regard des zones conductrices de la deuxième couche métallisée 30 et que ses plots de contact 51 soient électriquement connectés, par l'intermédiaire de ces zones conductrices et des puits conducteurs, aux plages de contact 21, 22 de la première couche métallisée 20. Un matériau adhésif non conducteur 52 est en général utilisé pour fixer efficacement la puce électronique sur son support.

Chaque module, conçu sur le film support, est ensuite découpé et collé dans une cavité prévue à cet effet dans un dispositif électronique, de sorte que les plages de contact affleurent la surface du dispositif. Ce genre de module électronique trouve application notamment dans les cartes à puce.

Cependant, un tel module réalisé selon cette technique FCOS présente des inconvénients. Le film support du module requiert notamment deux couches métallisées de part et d'autre du film diélectrique : une première couche externe supportant les plages de contact du bornier de connexion au format ISO 7816 et une deuxième couche interne formant des zones conductrices pour permettre de connecter les plots de contact de la puce électronique aux plages de contact de la première couche externe. Un tel module avec deux couches métallisées reste donc encore trop couteux. De plus, le fait de pratiquer des puits conducteurs dans la couche diélectrique est contraignant car les zones métallisées conductrices et les puits conducteurs correspondants, doivent alors être réalisés avec précision spécialement pour un modèle de puce donné. Par conséquent, le film support ne permet pas de s'adapter à n'importe quel modèle de puce si bien que, pour chaque type de puce à reporter dans un module, il est nécessaire de concevoir un film support spécifique. La conception d'un film support de modules, spécifique pour chaque type de puce, est donc très contraignante et implique également un coût élevé de fabrication.

L'invention a donc pour but de remédier à au moins un des inconvénients de l'art antérieur. En particulier, l'invention vise à proposer un module électronique simple à fabriquer, peu coûteux, et qui puisse s'adapter à tout type de puce électronique quelle que soit sa taille et plus généralement à tout type de composant électronique.

A cet effet, l'invention a pour objet un module électronique comportant un film diélectrique et une couche métallisée comprenant au moins une plage de contact d'un bornier de connexion, ledit module électronique étant **caractérisé en ce que** le film diélectrique forme une face externe dudit module et comprend au moins une ouverture ménagée dans son épaisseur et débouchant sur ladite au moins une plage de contact de la couche métallisée.

Ainsi, le module ne comprend qu'une seule couche métallisée, ce qui le rend moins coûteux. D'autre part, la couche métallisée devient la couche support de la puce électronique et des pistes d'interconnexion peuvent simplement et facilement être réalisées, juste avant le report de la puce, en fonction de sa taille. Le film support du module, formé par l'assemblage du film diélectrique et de la couche métallisée, peut alors s'adapter à n'importe quel type de puce.

Selon d'autres caractéristiques optionnelles du module électronique :
- le module comprend en outre une puce électronique électriquement connectée à ladite au moins une plage de contact et comporte une face cachée comprenant une première zone, comportant ladite au moins une plage de contact de ladite couche métallisée destinée à être visible de l'extérieur à travers ladite au moins une ouverture pratiquée dans ledit film diélectrique, et une deuxième zone de personnalisation destinée à recevoir au moins une piste d'interconnexion pour raccorder au moins un des plots de contact de ladite puce à ladite au moins une plage de contact,
- la zone de personnalisation fait partie de la couche métallisée,
- la puce électronique est reportée sur la zone de personnalisation, sa face active orientée en regard de ladite couche métallisée, au moins un de ses plots de contact étant connecté à ladite au moins une plage de contact par l'intermédiaire d'au moins une piste d'interconnexion,
- le module comprend en outre au moins un autre composant actif et/ou passif disposé dans la zone de personnalisation,
- le matériau de constitution du film diélectrique est choisi parmi l'un au moins des matériaux suivants : résine époxy renforcée fibres de verre, Polyéthylène téréphtalate, Polyimide, Polyéthylène naphtalate, Polychlorure de vinyle,
- le film diélectrique présente une épaisseur inférieure à 100 µm.

L'invention se rapporte aussi à un dispositif électronique comportant au moins un module électronique comprenant un film diélectrique et une couche métallisée, pourvue d'au moins une plage de contact d'un bornier de connexion accessible depuis la surface dudit dispositif et une puce dont au moins un plot de contact est électriquement relié à ladite au moins une plage de contact, **caractérisé en ce que** le film diélectrique dudit module affleure la surface du dispositif, au moins une ouverture, pratiquée dans l'épaisseur dudit film, débouchant sur ladite au moins une plage de contact pour la rendre accessible.

De manière avantageuse, le dispositif est une carte à puce.

L'invention se rapporte en outre à un procédé de fabrication d'un tel module électronique comportant un film diélectrique, une couche métallisée, pourvue d'au moins une plage de contact, et une puce électronique électriquement connectée à ladite au moins une plage de contact, ledit procédé étant **caractérisé en ce qu'il** comprend les étapes suivantes :
- pratiquer au moins une ouverture dans l'épaisseur du film diélectrique,
- assembler le film diélectrique et ladite couche métallisée, de sorte que ladite au moins une plage de contact soit disposée en regard de ladite au moins une ouverture,
- disposer ladite puce électronique, face active en regard de ladite couche métallisée, de manière à connecter électriquement au moins un de ses plots de contact à au moins une plage de contact de ladite couche métallisée par l'intermédiaire d'au moins une piste d'interconnexion.

Selon d'autres caractéristiques optionnelles du procédé de fabrication :
- l'étape d'assemblage consiste à assembler le film diélectrique sur un film métallique puis à réaliser la couche métallisée dans le film métallique préalablement assemblé en ménageant au moins une plage de contact dans ledit film métallique, ladite plage de contact étant disposée en regard de ladite au moins une ouverture, et en ménageant au moins une piste d'interconnexion, ladite piste d'interconnexion étant destinée à relier au moins un plot de contact de ladite puce électronique à ladite au moins une plage de contact,
- l'étape d'assemblage est réalisée par laminage,
- les étapes de réalisation de ladite au moins une plage de contact et de la dite au moins une piste d'interconnexion sont réalisées de manière simultanée par gravure laser dans ledit film métallique,
- l'étape de réalisation de ladite au moins une plage de contact est réalisée par gravure laser du film métallique, laissant apparaitre une zone de personnalisation sur la surface dudit film diélectrique, de part et d'autre de ladite au moins une plage de contact, et en ce que l'étape de réalisation de ladite au moins une piste conductrice est effectuée par injection de matière conductrice dans ladite zone de personnalisation,
- le procédé comprend une étape supplémentaire consistant à reporter au moins un autre composant actif et/ou passif sur une face cachée du module comprenant ladite couche métallisée,
- un composant passif est ajouté dans ladite zone de personnalisation par injection de matière conductrice,
- l'injection (ou dépôt) de matière conductrice est effectuée par jet d'encre (ou jet de matière), la matière conductrice étant choisie au moins parmi une encre à base de nanoparticules de métal, une encre à base de nanotubes de carbone ou de graphène, ou une encre à base de polymère conducteur,
- la puce électronique est reportée soit directement sur la face cachée du module comprenant la couche métallisée, soit dans une cavité d'un dispositif électronique, en regard de ladite face cachée.

D'autres particularités et avantages de l'invention apparaitront à la lecture de la description suivante faite à titre d'exemple illustratif et non limitatif, en référence aux Figures annexées qui représentent :
- La Figure 1, déjà décrite, une vue schématique en coupe d'un module électronique dont la puce électronique est connectée aux plages de contact par une technique de Flip Chip selon l'art antérieur
- La Figure 2, une vue schématique éclatée d'un module électronique réalisé selon un mode de réalisation de l'invention,
- La Figure 3, une vue schématique en coupe d'un module électronique selon l'invention encarté dans un corps de carte,
- Les Figures 4A et 4B, respectivement une vue schématique d'un film support de modules électroniques (autrement dit support de métallisation) selon l'invention, vu par sa face avant, et une vue schématique d'un autre film support de modules électroniques selon l'invention, vu par sa face arrière.

Dans la suite de la description, on entend par « face avant », « face visible », « face externe » ou « couche externe » d'un module électronique, la face destinée à affleurer la surface d'un dispositif électronique. Au contraire, on entend par « face arrière » ou « face cachée » la face du module qui est destinée à être logée dans la cavité d'un dispositif électronique et à être cachée de l'extérieur.

Le terme « couche métallisée » est utilisé pour désigner une couche comprenant des zones métalliques électriquement conductrices, délimitant par exemple des plages de contact. A contrario, le terme « film métallique » désigne une couche entièrement métallique sans délimitation de zones spécifiques.

La Figure 2 représente une vue schématique éclatée d'un module électronique selon l'invention (ou du moins le film support de métallisation de module notamment pour dispositif de type carte à puce lorsque il n'y a pas de puce de circuit intégré connectée). Ce module comprend, du côté de sa face avant AV, un film diélectrique 120. Ce film diélectrique 120 peut être une portion de feuille isolante ou d'un ruban isolant. Il recouvre une couche métallisée 110 pourvue de plages de contact 111 d'un bornier de connexion. Une puce électronique 130 est reportée sur la face arrière AR du module, et plus précisément sur la face arrière AR de la couche métallisée 110, opposée au film diélectrique 120. Les couches de constitution du film support du module sont donc inversées par rapport à un film support standard : la couche métallisée devient la couche support du composé électronique et le film diélectrique forme la couche externe du module.

Généralement, les films support de métallisation de modules sont connus par le terme « Lead-frame » (grille métallique conductrice gravée et/ou reportée sur un film diélectrique ou un isolant)

Pour pouvoir accéder aux plages de contact du bornier de connexion, depuis l'extérieur, des ouvertures 121 sont pratiquées dans l'épaisseur du film diélectrique 120, en regard de chaque plage de contact 111 de la couche métallisée 110 du dessous. L'emplacement des ouvertures 121 est donc conforme aux exigences de la norme ISO7816. De même, la taille des ouvertures 121 est au moins égale à la taille que doivent avoir des plages de contact selon la norme ISO 7816-2. Elle peut être légèrement supérieure du fait de l'épaisseur du film diélectrique.

L'épaisseur du film diélectrique doit en outre être suffisamment fine pour que la disposition des plages de contact du bornier de connexion du module par rapport à la surface d'un dispositif électronique, notamment d'une carte à puce, soit conforme aux exigences de la norme ISO7816. Pour cela, l'épaisseur du film diélectrique est inférieure à 100µm, et de préférence comprise entre 7 et 50µm.

Selon la destination finale du module électronique et la résistance désirée, le matériau diélectrique peut avantageusement être choisi au moins parmi les matériaux suivants : FR4 (de l'acronyme anglais Flame Resistant 4) qui est un matériau composite à base de résine époxy renforcée fibre de verre, PET (polyéthylène téréphtalate), un polyimide connu sous la marque Kapton, PEN (polyéthylène naphtalate), PVC (polychlorure de vinyle), etc...

La couche métallisée 110 comprend avantageusement deux zones. Une première zone 111 comprend au moins une plage de contact d'un bornier de connexion. En général un bornier de connexion d'un module comprend 6 ou 8 plages de contact. Ces plages de contact sont réalisées à des emplacements prescrits par la norme ISO7816, et leur taille est légèrement supérieure à celle prescrite par la norme ISO7816 afin que les plages de contact soient accessibles même sur les bords des ouvertures 121 pratiquées dans le film diélectrique.

Entre les plages de contact 111 de cette première zone et tout autour, est prévue une deuxième zone 112 A, 112B. Cette deuxième zone 112 A, 112B est dénommée zone de personnalisation. Elle permet d'y reporter la puce électronique 130, mais aussi d'autres composants actifs et/ou passifs. Avant le report de la puce 130 et des éventuels autres composants, des pistes d'interconnexion sont pratiquées dans cette zone de personnalisation afin de pouvoir connecter électriquement les plots de contact de la puce, et des éventuels autres composants, avec certaines plages de contact 111 du bornier de connexion.

Le film support du module, formé par l'assemblage du film diélectrique et de la couche métallisée, et la personnalisation du module sont réalisés selon le procédé décrit ci-après.

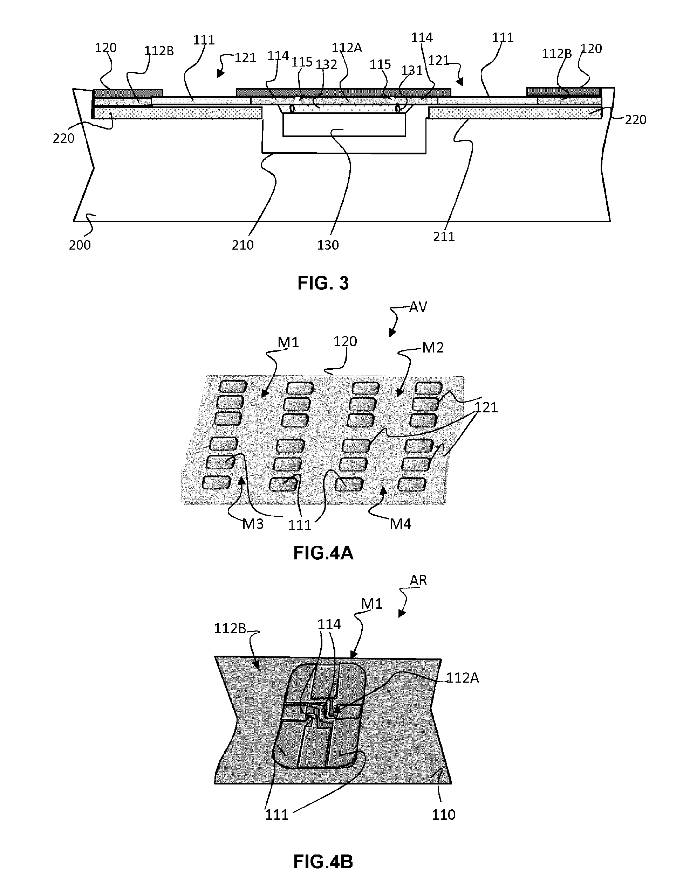

Dans un premier temps, les ouvertures 121 sont pratiquées dans le film diélectrique 120. Ce film se présente sous la forme d'une bande destinée à supporter des modules fabriqués en continu le long de la bande. La Figure 4A représente un exemple d'un tel film sur lequel sont représentés 4 modules M1, M2, M3, M4 vus par leurs faces avant. Le film diélectrique 120 pourvu de ses ouvertures 121 est ensuite assemblé avec la couche métallisée 110.

Dans un premier mode de réalisation, la couche métallisée 110 est préalablement réalisée selon un procédé classique de report de métal sur un substrat. Le substrat peut par exemple être une résine époxy renforcée fibres de verre. Le procédé classique utilisé peut par exemple être un procédé de photolithographie ou de croissance électrolytique ou encore de dépôt auto-catalytique. Cette couche métallisée comprend les plages de contact du bornier de connexion ainsi que les pistes d'interconnexion destinées à relier des plots de contact de la puce à reporter aux plages de contact. Dans ce premier mode de réalisation, la couche métallisée présente donc une architecture dédiée à un composant électronique. La couche métallisée est ensuite assemblée au film diélectrique par laminage par exemple.

Selon un deuxième mode de réalisation, le film diélectrique 120, pourvu de ses ouvertures 121, est préalablement assemblé, par laminage par exemple, à un film entièrement métallique dans lequel est ensuite réalisée la couche métallisée. Le film métallique est alors visible de la face avant AV à travers les ouvertures 121 du film diélectrique 120. Dans ce cas, les plages de contact 111, pistes d'interconnexion 114 et zone de report de composant sont définies, dans le film métallique, en une seule et même étape de gravure au laser. Pour cela, la face arrière AR du module électronique, c'est-à-dire le film métallique tel que schématisé sur la Figure 4B, est gravé au laser afin de dessiner les contours des plages de contact 111, et de réaliser les pistes d'interconnexion 114 en fonction de la puce à reporter. Cette étape de gravure permet de délimiter les contours des plages de contact et des pistes d'interconnexion et d'obtenir la couche métallisée 110 du module. Les pistes d'interconnexion sont réalisées en fonction de la puce à reporter, de sorte que les plots de contact de la puce puissent être connectés à des plages de contact correspondantes. Ainsi, le métal du film métallique est enlevé dans des zones de report de composant, qui ne correspondent ni aux plages de contact 111 ni aux pistes d'interconnexion 114. Il est en effet possible de reporter d'autres composants passifs et/ou actifs qui sont alors connectés aux plages de contact de la même manière, grâce à des pistes d'interconnexion réalisées entre les plages de contacts et les plots de contact des composants.

Selon un troisième mode de réalisation, le film diélectrique 120, pourvu de ses ouvertures 121, est préalablement assemblé à un film entièrement métallique dans lequel est ensuite réalisée la couche métallisée. Une fois les deux films assemblés par laminage par exemple, le film métallique est gravé au laser, de manière à enlever le métal du film métallique dans la zone de personnalisation 112A, 112B et ne conserver du métal que pour définir les plages de contact 111 du bornier de connexion. Dans ce cas, tout le métal autour du contour des plages de contact 111 est retiré au laser. Le film est donc perforé et il ne reste plus de métal dans la deuxième zone de personnalisation 112A, 112B qui est alors caractérisée par la surface à nu du film diélectrique 120. Seules les plages de contact restent donc assemblées au film diélectrique. Dans ce mode de réalisation on comprend d'autant plus la nécessité de définir les plages de contact à un format sensiblement plus grand que le format prescrit par la norme ISO 7816, afin que les plages de contact puissent être fixées sur le film diélectrique et qu'elles ne passent pas au travers des ouvertures 121. Les pistes d'interconnexion 114 entre les plages de contact et les plots de contact de la puce électronique et/ou du composant à reporter sont ensuite conçues par application d'une matière conductrice. Cette application est avantageusement réalisée par impression par jet d'encre. L'encre conductrice utilisée peut être choisie parmi : une encre à base de nanoparticules de métal, telles que des nanoparticules d'or, d'argent, de cuivre ou de palladium par exemple, une encre à base de nanotubes de carbone ou de graphène, ou encore une encre à base de polymère conducteur par exemple. Les pistes d'interconnexion ainsi réalisées et les plages de contact constituent alors la couche métallisée 110 du module.

Ce troisième mode de réalisation permet avantageusement de rajouter des composants passifs, simultanément à la conception des pistes d'interconnexion, grâce à l'impression par jet d'encre.

Une dernière étape après la conception des pistes d'interconnexion consiste à reporter la puce électronique et/ou d'éventuel(s) autre(s) composant(s) actif et/ou passif. Les plots de contact de la puce électronique sont avantageusement recouverts par des bossages conducteurs, couramment appelés « bumps » ou encore UBM (acronyme anglais pour « Under Bump Metalization ») selon la technologie utilisée pour les réaliser, référencés 131 sur la Figure 3, qui permettent d'assurer une continuité électrique entre les plots de contact de la puce et les pistes d'interconnexion.

La puce est avantageusement disposée de sorte que sa face active soit en regard de la couche métallisée 110 du module, et plus particulièrement en regard des pistes d'interconnexion 114. Elle peut être reportée soit directement sur la face cachée du module, et plus particulièrement sur la zone de personnalisation, soit être déportée et fixée dans la cavité d'un dispositif électronique par exemple.

La Figure 3 illustre de manière schématique une vue en coupe d'une portion de carte à puce 200 comprenant un module électronique selon l'invention, dont la puce 130 est fixée sur la face cachée du module au moyen d'une colle référencée 132. Dans ce cas, la puce étant reportée directement par sa face active, il n'est plus nécessaire de protéger ses connexions par une résine d'encapsulation puisque les connexions sont déjà protégées grâce à la colle. Par conséquent, le module obtenu dépend de l'épaisseur de la puce et peut donc être très fin par rapport aux modules de l'art antérieur.

Le corps de carte 200 comprend avantageusement une double cavité 210, 211. Une première cavité 210, plus profonde, est destinée à loger la puce, tandis que la deuxième cavité 211 concentrique, moins profonde mais de longueur plus élevée, permet de loger l'épaisseur du film support 110, 120 du module. Le module est fixé sur le fond de la deuxième cavité 211 grâce à un adhésif 220, par exemple un adhésif thermofusible. Cet adhésif permet ainsi de fixer directement les plages de contact du module et les pistes d'interconnexion dans le fond de la cavité 211. Les plages de contact 111 sont accessibles depuis l'extérieur grâce aux ouvertures 121 pratiquées dans l'épaisseur du film diélectrique 120 formant la face avant du module. Sur le schéma de la Figure 3 les pistes d'interconnexion 114 sont avantageusement obtenues par gravure 115 du film métallique au laser.

Dans un autre mode de réalisation, le film support du module, formé par l'assemblage du film diélectrique 120 et de la couche métallisée 110 est reporté et fixé par un adhésif dans la cavité 211 du corps de carte, au-dessus de la puce 130 préalablement fixée par sa face opposée à la face active, dans le fond de la cavité 210.

Ce module, réalisé de manière inversée par rapport aux modules existants jusqu'à présent, offre un grand avantage car il s'adapte à n'importe quelle taille de puce, puisque les pistes d'interconnexion sont réalisées juste avant le report de la puce en fonction de sa taille. Par ailleurs, la grande zone de personnalisation tout autour des plages de contact offre la possibilité des rajouter d'autres composants actifs et/ou passifs pour réaliser un module multi-composants. Une antenne peut également être prévue dans la zone de personnalisation, par gravure laser du film métallique ou par impression par jet d'encre conductrice. La cavité pratiquée dans le corps de carte est alors réalisée en fonction de la taille du module. D'autre part, la possibilité de concevoir des pistes conductrices et des composants passifs par impression d'encre conductrice est une solution très intéressante en termes de coût de fabrication. Le film support ne comprend qu'une seule couche métallisée sur une face du film diélectrique, ce qui le rend moins coûteux. De plus, le film support du module est adaptable à n'importe quel composant ce qui le rend également très intéressant car moins coûteux à fabriquer. Enfin, la fabrication du module est simple et rapide à mettre en oeuvre. De ce fait, l'invention permet de fabriquer un module adaptable à tout type de composant, de manière très simple et peu coûteuse.

## Revendications

1. Module électronique comportant un film diélectrique (120) et une couche métallisée (110) comprenant au moins une plage de contact (111) d'un bornier de connexion, ledit module électronique étant **caractérisé en ce que** le film diélectrique (120) forme une face externe dudit module et comprend au moins une ouverture (121) ménagée dans son épaisseur et débouchant sur ladite au moins une plage de contact (111) de la couche métallisée (110).

2. Module électronique selon la revendication 1, comprenant en outre une puce électronique (130) électriquement connectée à ladite au moins une plage de contact (111), **caractérisé en ce qu'il** comporte une face cachée comprenant une première zone, comportant ladite au moins une plage de contact (111) de ladite couche métallisée (110) destinée à être visible de l'extérieur à travers ladite au moins une ouverture (121) pratiquée dans ledit film diélectrique (120), et une deuxième zone de personnalisation (112A, 112B) destinée à recevoir au moins une piste d'interconnexion (114) pour raccorder au moins un des plots de contact de ladite puce à ladite au moins une plage de contact (111).

3. Module électronique selon la revendication 2, **caractérisé en ce que** la zone de personnalisation fait partie de la couche métallisée (110).

4. Module électronique selon l'une des revendications 2 à 3, **caractérisé en ce que** la puce électronique (130) est reportée sur la zone de personnalisation, sa face active orientée en regard de ladite couche métallisée (110), au moins un de ses plots de contact étant connecté à ladite au moins une plage de contact (111) par l'intermédiaire de ladite au moins une piste d'interconnexion (114).

5. Module électronique selon l'une des revendications 2 à 4, **caractérisé en ce qu'il** comprend en outre au moins un autre composant actif et/ou passif disposé dans ladite zone de personnalisation.

6. Module électronique selon l'une des revendications 1 à 5, **caractérisé en ce que** le matériau de constitution du film diélectrique (120) est choisi parmi l'un au moins des matériaux suivants : résine époxy renforcée fibres de verre, Polyéthylène téréphtalate, Polyimide, Polyéthylène naphtalate, Polychlorure de vinyle.

7. Module électronique selon l'une des revendications 1 à 6, **caractérisé en ce que** le film diélectrique (120) présente une épaisseur inférieure à 100µm.

8. Dispositif électronique comportant au moins un module électronique comprenant un film diélectrique (120), une couche métallisée (110), pourvue d'au moins une plage de contact (111) d'un bornier de connexion accessible depuis la surface dudit dispositif électronique, et une puce électronique (130) dont au moins un plot de contact est électriquement relié à ladite au moins une plage de contact (111), ledit dispositif électronique étant **caractérisé en ce que** le film diélectrique (120) dudit module affleure la surface du dispositif, au moins une ouverture (121), pratiquée dans l'épaisseur dudit film diélectrique, débouchant sur ladite au moins une plage de contact (111) pour la rendre accessible.

9. Dispositif électronique selon la revendication 8, **caractérisé en ce que** ledit dispositif est une carte à puce.

10. Procédé de fabrication d'un module électronique comprenant un film diélectrique (120), une couche métallisée (110), pourvue d'au moins une plage de contact (111), et une puce électronique (130) électriquement connectée à ladite au moins une plage de contact (111), ledit procédé étant **caractérisé en ce qu'il** comprend les étapes suivantes :
- pratiquer au moins une ouverture (121) dans l'épaisseur du film diélectrique (120),
- assembler le film diélectrique (120) et ladite couche métallisée (110), de sorte que ladite au moins une plage de contact soit disposée en regard de ladite au moins une ouverture (121),
- disposer ladite puce électronique (130), face active en regard de ladite couche métallisée (110), de manière à connecter électriquement au moins un de ses plots de contact à au moins une plage de contact (111) de ladite couche métallisée (110) par l'intermédiaire d'au moins une piste d'interconnexion (114).

11. Procédé de fabrication selon la revendication 10, **caractérisé en ce que** l'étape d'assemblage consiste à assembler le film diélectrique (120) sur un film métallique puis à réaliser la couche métallisée (110) dans le film métallique préalablement assemblé en ménageant au moins une plage de contact (111) dans ledit film métallique, ladite plage de contact étant disposée en regard de ladite au moins une ouverture (121), et en ménageant au moins une piste d'interconnexion (114) destinée à relier au moins un plot de contact de ladite puce électronique (130) à ladite au moins une plage de contact (111).

12. Procédé selon la revendication 11, **caractérisé en ce que** les étapes de réalisation de ladite au moins une plage de contact (111) et de la dite au moins une piste d'interconnexion (114) sont réalisées de manière simultanée par gravure laser dans le film métallique.

13. Procédé de fabrication selon la revendication 11, **caractérisé en ce que** l'étape de réalisation de ladite au moins une plage de contact (111) est réalisée par gravure laser du film métallique, laissant apparaitre une zone de personnalisation (112A, 112B) sur la surface dudit film diélectrique (120), de part et d'autre de ladite au moins une plage de contact (111), et **en ce que** l'étape de réalisation de ladite au moins une piste d'interconnexion (114) est effectuée par injection de matière conductrice dans ladite zone de personnalisation.

14. Procédé de fabrication selon l'une des revendications 10 à 13, **caractérisé en ce qu'il** comprend une étape supplémentaire consistant à reporter au moins un autre composant actif et/ou passif sur une face cachée du module comprenant ladite couche métallisée (110).

15. Procédé de fabrication selon les revendications 13 et 14, **caractérisé en ce qu'**un composant passif est ajouté dans ladite zone de personnalisation par injection de matière conductrice.

16. Procédé de fabrication selon l'une des revendications 13 ou 15, **caractérisé en ce que** l'injection de matière conductrice est effectuée par jet d'encre, la matière conductrice étant choisie au moins parmi une encre à base de nanoparticules de métal, une encre à base de nanotubes de carbone ou de graphène, ou une encre à base de polymère conducteur.

17. Procédé selon l'une des revendications 10 à 16, **caractérisé en ce que** la puce électronique (130) est reportée soit directement sur la face cachée du module comprenant la couche métallisée (110), soit dans une cavité (210) d'un dispositif électronique, en regard de ladite face cachée.
